# EUROPEAN PATENT SPECIFICATION

(11) **EP 3 456 698 B1**
(45) Date of publication and mention of the grant of the patent: **16.11.2022**
(21) Application number: 17190803.1
(22) Date of filing: 13.09.2017
(51) Int. Cl.: C04B 37/02, B23K 26/0622, B23K 26/351, H01L 49/02, H01C 17/242, B23K 26/03, H05K 3/02, H05K 1/16, H05K 1/03, H05K 1/02, B23K 26/00, B23K 26/082, B23K 26/361, B23K 26/40, B23K 101/38, B23K 103/12

(54) **METHOD FOR MANUFACTURING METAL-CERAMIC SUBSTRATE WITH TRIMMED RESISTORS**
VERFAHREN ZUR HERSTELLUNG EINES METALL-KERAMIK-SUBSTRATS MIT GETRIMMTEN WIDERSTÄNDEN
PROCÉDÉ DE FABRICATION D'UN SUBSTRAT MÉTAL-CÉRAMIQUE AVEC DES RÉSISTANCES ÉQUILIBRÉES

(43) Date of publication of application: 20.03.2019
(73) Proprietor: Infineon Technologies AG, 85579 Neubiberg (DE)
(72) Inventor: Roth, Alexander, 93197 Zeitlarn (DE)
(74) Representative: Dilg, Haeusler, Schindelmann Patentanwaltsgesellschaft mbH

(56) References cited:
- DE-A1-102012 206 973
- DE-A1-102013 102 540
- JP-A- H1 032 110
- US-A1- 2004 009 618
- US-A1- 2006 055 504

## Description

The invention relates to a method for manufacturing a metal-ceramic substrate according to the preamble of Claim 1, including providing a central ceramic insulation layer with a conductive metal layer on one or both of its surfaces.

Metal-ceramic substrates or ceramic substrates with metallizations are known as substrates for electrical and electronic circuits or modules, especially for high-power modules. Thereby, a metal can be applied to a ceramic substrate by Active-Metal-Brazing (AMB) or Direct-Aluminium-Bonding (DAB), for example. The power and current carrying capabilities of power switches are commonly limited by their package, because the package introduces thermal and electrical resistivity that can cause power loss and corresponding heating of the semiconductor die beyond its specified limits. Therefore, high power packages often use substrates like Direct-Bonded-Copper (DBC). A DBC substrate is a structure which provides for a low thermal resistivity, a very good thermal conductivity and a very good thermal cycling stability. A DBC substrate generally comprises a central insulation layer, which has top and bottom conductive copper layers on its top and bottom surfaces. These are frequently copper. The central insulation layer may be a ceramic material like aluminium-oxide or aluminium nitride.

Certain resistances are achieved on metal-ceramic substrates, for example shunt resistors or gate resistors. Typically, separate passive components are used to achieve these resistances. In the field of thick-film resistors it is known to trim resistors in order to set a required resistivity value. For example, specially printed resistivity paste is fired and cut while simultaneously monitoring the resistivity value. Thereby, single cuts, double cuts or L-cuts can be used, for example. All kinds of ablative processes can be used to apply the cuts, though commonly laser ablation emerged as a method of choice. Common to these trimmings is that a side cut is always performed from the top to the bottom, which means that a full cut is applied in the z-axis while the remaining resistor thickness remains at 100% of the starting resistivity.

US 2006/0055504 A1 discloses a method for manufacturing a metal-ceramic substrate according to the preamble of claim 1. Other methods are known from DE 10 2012 206 973 A1 and DE 10 2013 102 540 A1.

However, unlike thick film, substrates for high voltage are not easily suitable for trimming. Conventional laser systems carry the risk to damage the isolator and/or induce cracks during trimming which later lead to failure in thermal cycling. That is why there is a need for a solution to implement trimming on the substrate level and to eliminate a separate resistor.

According to the invention, this object is achieved with a method for manufacturing a metal-ceramic substrate according to the independent Claim 1. Advantageous embodiments of the method result from dependent Claims 2-7.

The method according to the invention is used for manufacturing a metal-ceramic substrate. This metal-ceramic substrate can be an AMB substrate (Active-Metal-Brazing) or a DAB substrate (Direct-Aluminium-Bonding), for example. In one embodiment of the invention, it is a DCB substrate which is a so-called Direct-Copper-Bonding substrate which is also known as DBC substrate (Direct Bond Copper). DCB substrates are suited to high power applications that demand a high level of heat dissipation. Thus, the DCB substrate is a high power substrate. Thereby, a central ceramic insulation layer is provided with a conductive metal layer on one or both of its surfaces. In case the conductive metal layer is made of copper, this copper is applied to the central ceramic insulation layer by means of a DCB process. The central insulation layer is a ceramic layer like an alumina layer made of Al₂O₃ or aluminium nitride, for example. Alternatively, beryllium oxide (BeO) can be used. A sheet of copper is commonly bonded to one or both sides of this central insulation layer by a high-temperature oxidation process. An electrical circuit is formed at least in a top copper layer by preforming, firing and/or chemical etching. A bottom copper layer can be kept plain. However, the invention can be used for manufacturing substrates with different kinds of metal layers. For example, it could also be used for ceramic substrates with conductive metal layers made of aluminium instead of copper. In addition to Al₂O₃, AlN and BeO, silicon nitride (Si₃N₄) or similar ceramic materials can be used to form the central ceramic insulation layer.

According to the invention, laser ablation with an ultrashort pulse laser is performed locally on at least one conductive metal layer within a certain ablation area. This laser ablation is performed until a certain resistivity of the conductive metal layer is achieved in this ablation area, whereby the thickness of the conductive metal layer in the ablation area is reduced to a value above zero. The metal layer is ablated in the z-axis which is orthogonal to the surface of the central ceramic insulation layer. Thus, the metal layer is trimmed by reducing its thickness in a certain ablation area, but the metal layer is not fully removed by laser ablation in this region. This z-axis trimming can be performed on one or both metal layers of a substrate. If more than one metal layer is trimmed, an ablation area is defined for each metal layer. Further, more than one ablation area can be defined in a metal layer.

The ablation consists of a series of discrete single laser pulses which remove material from the ablation area. Thereby, the cross-section of the metal layer is reduced in the ablation area, which increases the electrical resistivity in this area. With this method, certain resistance values can be achieved in a metal layer of a metal-ceramic substrate to form resistors like shunt resistors or gate resistors, for example. Thereby, no separate passive components are needed, which saves material and manufacturing time. In addition, the required resistance values can be adjusted very precisely. Thus, the invention allows to implement trimming on the substrate level and to eliminate separate resistors.

With oxygen-free copper, for example, electrical resistance values from about 1 mOhm to 1 kOhm can be achieved, whereby large resistance values can require further measures. For large electrical resistance values, the z-axis trimming can be combined with a known side cut, for example. In addition to the trimming steps at least one full side cut is produced across the thickness of the conductive metal layer which locally reduces said thickness to zero in the ablation area. Thus, the width of the ablation area is reduced by a full side cut and its thickness is reduced by a partial ablation, which results in a significantly reduced cross-section.

Preferably, the resistivity of the conductive metal layer is measured during the laser ablation, and the laser ablation is performed until a target value of resistivity is reached. Thus, the resistivity value is monitored simultaneously during laser ablation so that the resistivity can be adjusted very precisely.

The use of ultrashort pulse lasers is advantageous, because its ultrashort duration prevents thermal degradation of the to-be-ablated base material and enables an extremely precise cut. Especially the processing of copper using ultrashort pulses provides for a very precise ablation and high removal rates. Thereby, the duration of the pulse ranges between 200 fs and 10 ps.

In one embodiment of the invention, laser beams are raster scanned across the ablation area to perform a scanning ablation. This means that laser beams are guided to the metal surface in rectangular patterns consisting of overlapping parallel lines, for example. With an increasing number of raster scans in the ablation area, the depth of the irradiated area increases. Thereby, the laser beams are deflected and focused. For example, a galvanometer scan system is used to deflect the laser beams, and an objective is used to focus the laser beams to focus spots with diameters in the range of about 20 to 30 µm.

The laser parameters are chosen to meet specific requirements. In particular, the laser parameters are chosen to achieve high material removal rates. For example, the laser ablation is performed with a pulse repetition frequency f_{R} in the range of 1 to 20 MHz, in particular in the range of 6 to 7 MHz. Further, the laser ablation is performed with a pulse energy Q_{SP} in the range of 1 to 50 µJ, in particular in the range of 4 to 6 µJ. Preferably, a wavelength is used that optimizes absorption in the metal layer, while minimizing absorption of the ceramic insulation layer. The wavelength can be chosen about 1026 nm or 1030 nm, for example. High material removal rates can be found with pulses of about 5 µJ energy at about 6.5 MHz repetition frequency, for example. In one embodiment of the invention, the thickness of a metal layer on a substrate is between 0.2 to 0.5 mm, in particular about 0.3 mm. With this starting thickness of about 0.3 mm, a thickness reduction by means of the laser ablation between 0.1 and 0.295 mm is performed.

The invention also covers a corresponding metal-ceramic substrate, including a central ceramic insulation layer with a conductive metal layer on one or both of its surfaces. In one embodiment of the invention the conductive metal layer is made of copper which is applied to the central ceramic insulation layer by means of a DCB process. Within an ablation area the thickness of the conductive metal layer is reduced compared to adjacent regions, whereby said thickness is reduced to a value above zero. This metal-ceramic substrate can be manufactured with a method according to an embodiment of the method according to the invention. For example, in addition to a reduction of thickness to a value above zero, the conductive metal layer can comprise at least one full cut across the thickness which locally reduces said thickness to zero in the ablation area. For example, a DCB substrate with a standard side cut can be provided with a copper layer with a large local resistance, in particular with local resistance values between 34 and 1,400 Ohm.

In one embodiment of the invention, an ablation area in the conductive metal layer is defined by a web or band between two layer regions of metal. On a DCB substrate, this web is produced by etching after the DCB process, for example. Other advantages, special features and useful further developments of the invention result from the dependent claims and the preferred embodiments shown below by means of the figures, where
- Fig. 1: shows a schematic top view on a DCB substrate obtained by a method according to an embodiment of the invention;
- Fig. 2: shows a schematic side view of the substrate of Fig. 1 before trimming;
- Fig. 3: shows the substrate of Fig. 2 after trimming; and
- Fig. 4: shows a schematic top view on an ablation area during raster scanning.

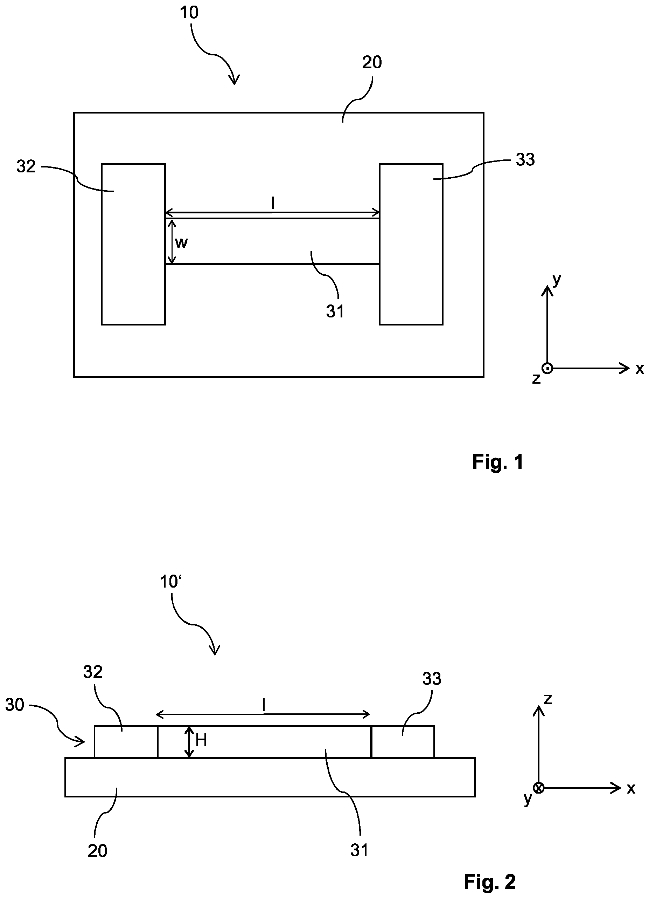

The schematic view of Fig. 1 shows a first embodiment of a DCB substrate 10 obtained by a method according to the invention. The invention will be described exemplarily on the basis of a DCB substrate. However, the invention can also be used for manufacturing different kinds of metal-ceramic substrates so that the following description can be applied to different kinds of substrates. For example, the substrate can be an AMB substrate with copper layer(s) or an DAB substrate with aluminium layer(s). In any case, one or more metal layers are applied to a central ceramic insulation layer and at least one trimmed resistor is formed in at least one metal layer.

The metal-ceramic substrate 10 shown in Fig. 1 comprises a central ceramic insulation layer 20 which has a rectangular shape. A top conductive copper layer has been applied to the top surface of the insulation layer 20 by a common DCB process for bonding copper directly to the central insulation layer 20. In this embodiment, the copper layer consists of two rectangular layer regions 32 and 33, and a web or narrow band connecting the two layer regions 32, 33. This web forms an ablation area 31 in which the thickness of the copper is reduced compared to the two layer regions 32 and 33. Thus, the thickness of the copper layer in the ablation area 31 is smaller than in the layer regions 32 and 33, which has been achieved by laser ablation with ultrashort pulses in the z-axis.

More than one ablation area can be defined on a copper layer, and top and/or bottom copper layers can be trimmed on an insulation layer 20. Furthermore, the ablation area and adjacent layer regions can have different shapes. Thus, the invention is not limited to a DCB substrate according to Fig. 1 since this schematic top view only serves for illustrating the principles of the invention.

The ablation area 31 has a length I in the x-axis and a width w in the y-axis. Before trimming of the ablation area 31 in the z-axis, the starting thickness H of the top copper layer 30 basically corresponds to the thickness of the adjacent layer regions 32, 33, as can be seen in the schematic side view of Fig. 2. Fig. 2 shows a DCB substrate 10 before trimming of the ablation area 31. The length I and the cross-section A = w^{∗}H of the ablation area 31 lead to a certain starting value for the electrical resistivity. Thereby, the electrical resistivity of oxygen-free copper is = 0.01721 Ohm mm²/m, which means that the electrical resistance R = 0.01721 Ohm mm²/m ^{∗} l/ (w^{∗}H) for the ablation area 31. With a constant length I and a constant width w of the ablation area 31, the electrical resistivity of the copper layer 30 in the ablation area 31 is reduced by reducing the thickness H of the ablation area 31.

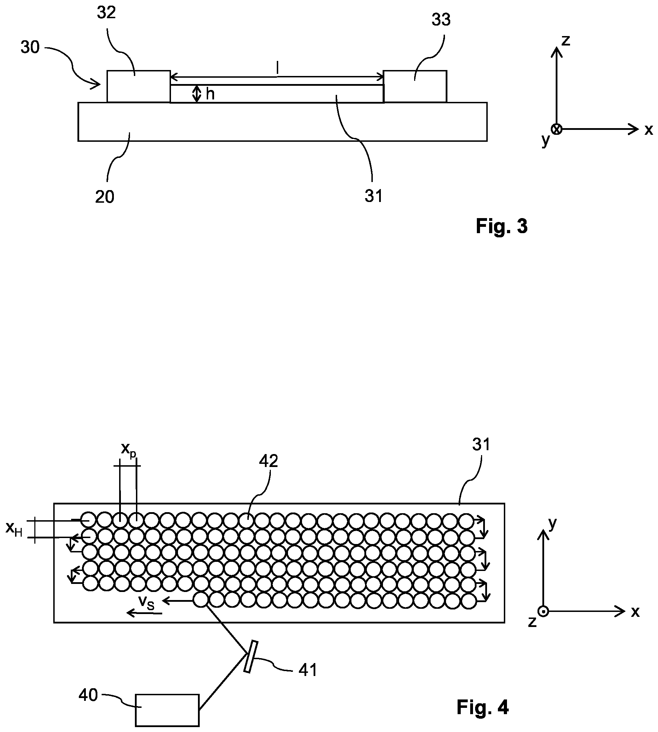

Optionally, the width w of the ablation area 31 can also be reduced by laser ablation in order to increase the reduction of the cross-section A. Consequently, the width w of the ablation area 31 in Fig. 1 has been produced by etching or by laser trimming. Fig. 3 shows a schematic side view of the resulting DCB substrate 10 after trimming, i.e. after reduction of the thickness of the copper layer 30 to a certain value h. The difference H h is the thickness reduction by laser ablation.

With a starting thickness H = 0.3 mm, the following electrical resistances can be achieved for seven exemplary embodiments of a DCB substrate. Embodiments 5-7 are obtained by a method according to the invention:

| | Width w of original ablation area [mm] | Length I of original ablation area [mm] | Thickness reduction H-h [mm] | Resulting cross-section A [mm²] | Electrical resistance [Ohm] |
|---|---|---|---|---|---|
| 1 | 1 | 1 | 0.1 | 0.2 | 0.0861 |
| 2 | 5 | 1 | 0.1 | 1 | 0.0172 |
| 3 | 10 | 1 | 0.1 | 2 | 0.0086 |
| 4 | 0.7 | 1 | 0.295 | 0.0035 | 4.9171 |
| 5 | 0.1 | 1 | 0.295 | 0.0005 | 34.4200 |
| 6 | 0.1 | 5 | 0.295 | 0.0005 | 172.1000 |
| 7 | 0.05 | 20 | 0.295 | 0.00025 | 1,376.8000 |

In embodiments 1-4, the width w of the original ablation area is defined by the original layout from etching of the conductive copper layer. The length I is always 1 mm. By thickness reductions between 0.1 and 0.295 mm the resulting cross section A = w^{∗}h is between 0.2 and 0.0035. This results in electrical resistance values in the trimmed ablation area between 0.0861 and 4.9171 Ohm.

For larger resistance values, the width w can be reduced and/or the length I of an ablation area can be increased. This is shown in the exemplary embodiments 5-7 and can also be achieved by laser trimming, whereby a full cut is used from the top to the bottom of the top copper surface 30. In embodiment 5, the width w is reduced to 0.1 mm, for example by laser ablation and the length I is kept at 1 mm. With a thickness reduction of 0.295 mm, this results in a cross-section A of 0.0005 mm² and a resistance value of 34.4200 Ohm. With an increased length I, the same width w and the same thickness reduction of the ablation area lead to a resistance value of 172.1000 Ohm (embodiment 6). If the width w is further reduced and the length I of the ablation area is further increased like in embodiment 7, a high resistance value of 1,376.8000 Ohm can be achieved with a thickness reduction of 0.295 mm. Preferably, the width w and/or the length I is trimmed before the thickness of the ablation area is reduced by laser ablation to the final value.

The laser ablation of an ablation area 31 is performed with a series of discrete ultrashort single laser pulses which remove material from the ablation area which reduces the thickness of a copper layer in this ablation area. The resulting resistivity is simultaneously measured and ablation is terminated once a target resistivity value is reached. Preferably, laser ablation of an ablation area 31 is performed with a scanning ablation. Thereby, the laser beam is deflected from pulse to pulse and this deflection from pulse to pulse is minimized in order to maximize pulse frequency and process speed. Fig. 4 shows a schematic top view on an ablation area 31 during raster scanning which is used to explain the basic principle of raster scanning. Laser beams from a laser device 40 are deflected by a deflection system 41, e.g. a galvanometer scan system. The laser beams are focused and guided to the ablation area 31 in order to form laser spots 42 which run in rectangular patterns consisting of several parallel lines. With an increasing number of raster scans in the ablation area, the depth of the irradiated area increases. The diameter of the laser spots 42 is between 20 and 30 µm. The spacing between lines of laser spots 42 is the hatch distance x_{H}, whereas the distance between the laser spots 42 along a line is defined by the pulse spacing xₚ. This pulse spacing depends on the scan speed vₛ or the pulse repetition frequency f_{R} or both (vₛ = x_{H} ^{∗} f_{R}).

### Reference numbers

- 10,10: substrate, DCB substrate
- 20: insulation layer
- 30: top conductive copper layer
- 31: ablation area
- 32,33: layer region
- 40: laser device
- 41: deflection system
- 42: laser spot

- w: width
- I: length
- H: starting thickness
- h: reduced thickness
- xₚ: pulse spacing
- x_{H}: hatch distance
- vₛ: scan speed

## Claims

1. A method for manufacturing a metal-ceramic substrate (10), including providing a central ceramic insulation layer (20) with a conductive metal layer (30) on one or both of its surfaces,
wherein laser ablation with an ultrashort pulse laser having a pulse duration between 200 fs and 10 ps is performed on at least one conductive metal layer (30) locally within an ablation area (31) until a certain resistivity of the conductive metal layer (30) is achieved in this ablation area (31), whereby the thickness of the conductive metal layer (30) in the ablation area (31) is reduced to a value above zero,
**characterized in that**
additionally, at least one full side cut is produced across the thickness of the conductive metal layer (30) which locally reduces said thickness to zero in the ablation area (31), thereby reducing the width of the ablation area (31).

2. The method according to Claim 1,
**characterized in that** the resistivity of the conductive metal layer (30) is measured during the laser ablation and the laser ablation is performed until a target value of resistivity is reached.

3. The method according to one of Claims 1 to 2,
**characterized in that** laser beams are raster scanned across the ablation area (31) to perform a scanning ablation.

4. The method according to one of Claims 1 to 3,
**characterized in that** the laser ablation is performed with a pulse repetition frequency between 1 to 20 MHz.

5. The method according to one of Claims 1 to 4,
**characterized in that** the laser ablation is performed with a pulse energy between 1 and 50 µJ.

6. The method according to one of Claims 1 to 5,
**characterized in that** the starting thickness of the conductive metal layer (30) in the ablation area (31) is about 0.3 mm, and the thickness reduction by means of the laser ablation is between 0.1 and 0.295 mm.

7. The method according to one of Claims 1 to 6,
**characterized in that** the conductive metal layer (30) is made of copper which is applied to the central ceramic insulation layer (20) by means of a Direct Copper bonding- (DCB-) process.

## Patentansprüche

1. Verfahren zum Herstellen eines Metall-Keramik-Substrats (10), bei dem eine zentrale keramische Isolierschicht (20) mit einer leitenden Metallschicht (30) auf einer oder beiden ihrer Oberflächen versehen wird,
wobei eine Laserablation mit einem Ultrakurzpulslaser mit einer Pulsdauer zwischen 200 fs und 10 ps an mindestens einer leitenden Metallschicht (30) lokal innerhalb eines Ablationsbereichs (31) durchgeführt wird, bis ein bestimmter spezifischer Widerstand der leitenden Metallschicht (30) in diesem Ablationsbereich (31) erreicht ist, wodurch die Dicke der leitenden Metallschicht (30) in dem Ablationsbereich (31) auf einen Wert über Null reduziert wird,
**dadurch gekennzeichnet, dass**
zusätzlich mindestens ein Vollseitenschnitt über die Dicke der leitenden Metallschicht (30) erzeugt wird, der die Dicke im Ablationsbereich (31) lokal auf Null reduziert, wodurch die Breite des Ablationsbereichs (31) verringert wird.

2. Verfahren nach Anspruch 1,
**dadurch gekennzeichnet, dass** der spezifische Widerstand der leitenden Metallschicht (30) während der Laserablation gemessen wird und die Laserablation durchgeführt wird, bis ein Zielwert des spezifischen Widerstands erreicht wird.

3. Verfahren nach einem der Ansprüche 1 bis 2,
**dadurch gekennzeichnet, dass** die Laserstrahlen über den Ablationsbereich (31) gerastert werden, um eine Abtastablation durchzuführen.

4. Verfahren nach einem der Ansprüche 1 bis 3,
**dadurch gekennzeichnet, dass** die Laserablation mit einer Pulswiederholfrequenz zwischen 1 und 20 MHz durchgeführt wird.

5. Verfahren nach einem der Ansprüche 1 bis 4,
**dadurch gekennzeichnet, dass** die Laserablation mit einer Pulsenergie zwischen 1 und 50 µJ durchgeführt wird.

6. Verfahren nach einem der Ansprüche 1 bis 5,
**dadurch gekennzeichnet, dass** eine Ausgangsdicke der leitenden Metallschicht (30) im Ablationsbereich (31) etwa 0,3 mm beträgt und die Dickenreduktion durch den Laserabtrag zwischen 0,1 und 0,295 mm liegt.

7. Verfahren nach einem der Ansprüche 1 bis 6,
**dadurch gekennzeichnet, dass** die leitende Metallschicht (30) aus Kupfer beschaffen ist, das mittels eines Direct-Copper-Bonding- (DCB-) Verfahrens auf die zentrale keramische Isolierschicht (20) aufgebracht wird.

## Revendications

1. Procédé de fabrication d'un substrat métal-céramique (10), comprenant la fourniture d'une couche d'isolation céramique centrale (20) avec une couche métallique conductrice (30) sur l'une de ses surfaces ou les deux,
dans lequel une ablation laser avec un laser à impulsions ultracourtes présentant une durée d'impulsion entre 200 fs et 10 ps est réalisée sur au moins une couche métallique conductrice (30) localement à l'intérieur d'une zone d'ablation (31) jusqu'à ce qu'une certaine résistivité de la couche métallique conductrice (30) soit atteinte dans cette zone d'ablation (31), ce qui permet de réduire l'épaisseur de la couche métallique conductrice (30) dans la zone d'ablation (31) à une valeur supérieure à zéro,
**caractérisé en ce que**
de plus, au moins une découpe latérale complète est produite à travers l'épaisseur de la couche métallique conductrice (30) qui réduit localement ladite épaisseur à zéro dans la zone d'ablation (31), réduisant ainsi la largeur de la zone d'ablation (31).

2. Procédé selon la revendication 1,
**caractérisé en ce que** la résistivité de la couche métallique conductrice (30) est mesurée au cours de l'ablation laser et l'ablation laser est réalisée jusqu'à ce qu'une valeur cible de résistivité soit atteinte.

3. Procédé selon la revendication 1 ou 2,
**caractérisé en ce que** des faisceaux laser font l'objet d'un balayage tramé sur la zone d'ablation (31) pour réaliser une ablation par balayage.

4. Procédé selon l'une des revendications 1 à 3,
**caractérisé en ce que** l'ablation laser est réalisée avec une fréquence de répétition d'impulsion entre 1 et 20 MHz.

5. Procédé selon l'une des revendications 1 à 4,
**caractérisé en ce que** l'ablation laser est réalisée avec une énergie d'impulsion entre 1 et 50 µJ.

6. Procédé selon l'une des revendications 1 à 5,
**caractérisé en ce que** l'épaisseur de départ de la couche métallique conductrice (30) dans la zone d'ablation (31) est d'environ 0,3 mm, et la réduction d'épaisseur au moyen de l'ablation laser est entre 0,1 et 0,295 mm.

7. Procédé selon l'une des revendications 1 à 6,
**caractérisé en ce que** la couche métallique conductrice (30) est constituée de cuivre qui est appliqué sur la couche d'isolation céramique centrale (20) au moyen d'un processus de liaison en cuivre directe (DCB) .
